# EUROPEAN PATENT APPLICATION

(11) **EP 1 788 694 A1**
(43) Date of publication of application: **23.05.2007**
(21) Application number: 05766499.7
(22) Date of filing: 13.07.2005
(51) Int. Cl.: H02K 41/03, G03F 7/20, H01L 21/027, H02K 41/02

(54) **PLANAR MOTOR EQUIPMENT, STAGE EQUIPMENT, EXPOSURE EQUIPMENT AND DEVICE MANUFACTURING METHOD**

(30) Priority: 15.07.2004 JP 2004208574
(71) Applicant: NIKON CORPORATION, Tokyo 100-8331 (JP)
(72) Inventor: ONO, Kazuya c/o Nikon Corporation, Chiyoda-ku, Tokyo 100-8331 (JP)
(74) Representative: HOFFMANN EITLE
(86) International application number: PCT/JP2005/013339
(87) International publication number: WO 2006/006730

(57) **Abstract**

A planar motor device and the like which can shift at a high acceleration, provide a high aligning accuracy and can be efficiently driven is provided. The planar motor (15) includes a fixed part (16) provided on a base member (14), and a moving part (17) provided on a stage unit (WST1). The fixed part (16) is provided with core members (22), which are arranged at prescribed intervals within an XY plane with a coil (21) wound around, and leading edge parts of head parts (22a) of the core members (22) are set to be within a substantially one plane. On the bottom plane of a first stage (25) of the stage unit (WST1), permanent magnets (26) are arranged at prescribed intervals in an X direction and a Y direction.

## Description

### TECHNICAL FIELD

The present invention relates to planar motor device which two-dimensionally drives a moving part with respect to a fixed part, stage device including the planar motor device as driving means, and exposure device including the stage device.

This application claims priority to Japanese Patent Application No. 2004-208574, filed on July 15, 2004, the contents of which are incorporated herein by reference.

### BACKGROUND ART

In a photolithography process provided as one of the manufacturing processes for a semiconductor device, a liquid crystal display device, a charge coupled device (CCD) or other imaging devices, a thin film magnetic head, or other various devices, such exposure device is used that transfers a pattern formed on a mask or reticle (hereinafter, generally referred to as "mask") through a projection optical system onto a substrate such as a glass plate or a wafer the surface of which is coated with a photoresist. In the exposure device, the substrate is held by vacuum suction or the like on a substrate holder with the substrate holder fixed to a substrate table due to a need to align the substrate to an exposure position at a high aligning accuracy.

In recent years, it is required to move the substrate at a higher speed to improve the throughput (the number of substrates that can be processed by exposure per unit time). Moreover, miniaturization of a pattern transferred to the substrate requires the substrate to be aligned with high accuracy without being affected by the precision of a mechanical guideway or the like. Furthermore, life extension is required by avoiding mechanical friction to elongate the operation time of the exposure device by decreasing the maintenance opportunities. To satisfy these requirements, stage device is developed that aligns a substrate by two-dimensionally driving a substrate table on which the substrate is mounted in a noncontact manner. As for a driving source of the noncontact driving stage device, there is known, for example, a planar motor having a structure in which the two axes of vafiable-magnetic-resistance drive type linear pulse motors are coupled together.

At present, the linear pulse motor of the variable-magnetic-resistance drive type mainly has the structure in which the two axes of variable-naagnetic-resistance drive type linear pulse motors are coupled together as in a Sawyer motor. The variable-magnetic-resistance drive type linear pulse motor includes, for example, a stator composed of a plate magnetic material having irregular teeth formed thereon at regular intervals along a longitudinal direction and a mover facing the irregular teeth of the stator and having a plurality of armature coils coupled together via permanent magnets with irregular parts different in phase from the irregular teeth, thereby driving the mover through the use of a force generated to minimize a magnetic resistance between the stator and the mover at each time point.

In recent years, there has also been suggested a planar motor including, for example, a stator having two-dimensionally arranged coils and a mover having two-dimensionally arranged permanent magnets, wherein the mover is two-dimensionally driven relative to the stator by using a Lorentz force generated by applying current to the coils. For details of the planar motor, refer to, for example, Japanese Patent Laid-Open No. Hei 11(1999)-164543, Japanese Patent Laid-Open No. 2003-224961, and the specification of US Patent No. 5,677,758, The disclosure of the above publications and US Patent is incorporated herein as part of this specification within a range of permission of the domestic laws and ordinances of the countries designated (or selected) in this international application.

Meanwhile, recently further improvement of throughput is required and therefore a substrate stage is required to move at higher acceleration. To increase the acceleration of the substrate stage, there is a need to increase a thrust force applied to the substrate stage. The thrust force can be increased by increasing current applied to the coils or upsizing the permanent magnets to increase the magnetic flux density formed by the permanent magnets, In the above planar motor, however, the heating value increases when heavy current is applied to the coils and the heat generated by the coils causes, for example, a mechanical error due to expansion of members constituting the substrate stage, which results in deterioration of aligning accuracy.

On the other hand, upsizing the permanent magnets to increase the magnetic flux density increases the weight of the moving part. The increase in the weight of the moving part disables the increase in acceleration even if the thrust force increases or rather it may cause deterioration in the aligning accuracy of the substrate stage, In addition, if the weight of the moving part increases, there is a need to apply further heavy-current to the coils to increase the acceleration inefficiently. On the other hand, downsizing the permanent magnets reduces the weight of the moving part, but decreases the magnetic flux density formed by the permanent magnets, which causes a need to apply more current to the coils to achieve the same thrust force.

The present invention has been made in view of the above circumstances, and it is an object of the present invention to provide planar motor device which can move at high acceleration, provide a high aligning accuracy, and provide drive efficiently, stage device having the planar motor device as driving means, and exposure device having the stage device.

### DISCLOSURE OF THE INVENTION

In order to solve the above problem, the planar motor device according to the present invention includes a fixed part (16) which forms a predetermined moving surface and a moving part (17) which is movable along the moving surface, wherein the fixed part includes a plurality of core members (22) arranged along the moving surface and each including a magnetic material and coils (21) magnetically connected to the core members, respectively, and wherein the moving part includes magnetic members (26) arranged along the moving surface on the side opposite to the fixed part.

According to the present invention, the magnetic flux generated by each of the coils is guided to the moving surface through the core member magnetically connected to the coil and repulses or attracts the magnetic flux generated by the magnet provided in the moving part, The repulsion or attraction generates a thrust force in the moving part and thereby the moving part moves along the moving surface.

In addition, the stage device (RST, WST) according to the present invention has stages (25, 28) on which an object (R, W) is mounted, having the above planar motor device as driving means for the above stages.

Furthermore, the exposure device (10) according to the present invention includes a mask stage (RST) which holds a mask (R) and a substrate stage (WST) which holds a substrate (W) and transfers a pattern formed on the mask onto the substrate, with the stage device provided as at least one of the mask stage and the substrate stage.

According to the present invention, the magnetic flux generated by the coil is guided to the moving surface opposite to the magnets disposed in the moving part through the core member. Therefore, the magnets of the moving part can be downsized without reducing the thrust force to thereby reduce the weight of the moving part. Accordingly, the present invention has effects that the moving part can move at high acceleration and provide a high aligning accuracy. Moreover, the magnetic flux generated by the coil can be effectively used, which leads to an effect that the moving part can be driven efficiently.

Furthermore, according to the present invention, the stage can move at high acceleration and therefore the invention has an effect that an object can be conveyed at high speed in a short period of time.

Still further, according to the present invention, the planar motor can move at least one of the mask stage and substrate stage provided in the exposure device at high acceleration with high accuracy. Therefore, the invention has an effect that can transfer a micropattern with high accuracy and high throughput.

### BRIEF DESCRIPTION OF THE DRAWINGS

FIG. 1 is a diagram illustrating a schematic configuration of exposure device according to one embodiment of the present invention,
FIG. 2 is a top view illustrating the configuration of a wafer stage WST.
FIG. 3 is a top view of a stage unit WST1 provided on the wafer stage WST.
FIG. 4 is a cross-sectional view on arrow A-A of FIG. 3.
FIG. 5 is an enlarged view of a core member 22.
FIG. 6 is a cross-sectional view on arrow B-B of FIG. 4.
FIG. 7 is a cross-sectional view on arrow C-C of FIG. 4.
FIG. 8 is a flowchart showing a part of a manufacturing process for manufacturing a liquid crystal display device as a micro device.
FIG. 9 is a flowchart showing a part of a manufacturing process for manufacturing a semiconductor device as a micro device.
FIG. 10 is a diagram showing an example of a detailed flow of step S13 in FIG. 9.

### BEST MODE FOR CARRYING OUT THE INVENTION

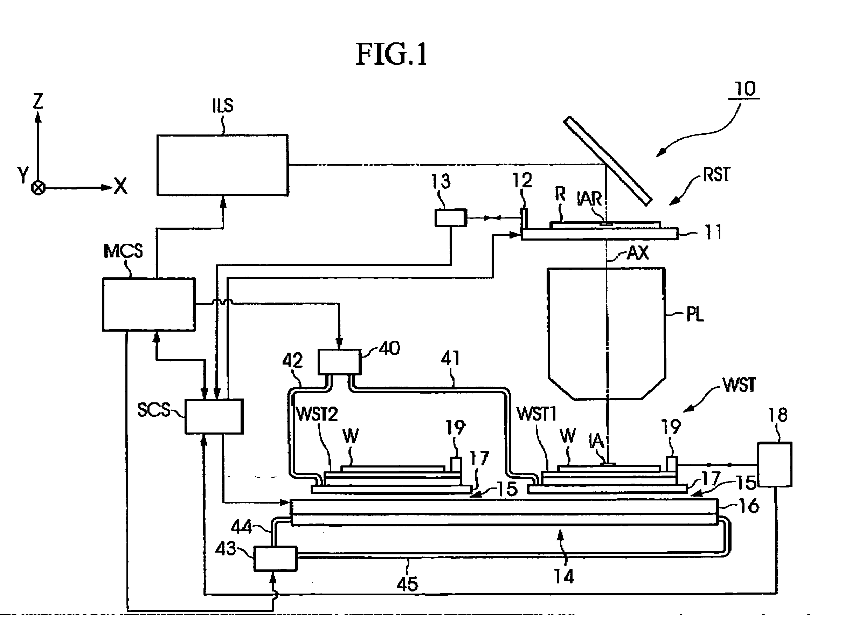

The following describes in detail planar motor device, stage device, and exposure device according to one embodiment of the present invention with reference to the drawings. Referring to FIG. 1, there is shown a diagram of a schematic configuration of the exposure device according to the embodiment of the present invention. The exposure device 10 shown in FIG. 1 is for use in manufacturing a semiconductor device and it is reduced projection type exposure device employing a step-and-scan system in which patterns formed on a reticle R are transferred sequentially onto a wafer W while the reticle R and the waver W are synchronously moved.

The following describes a positional relation between members with reference to an XYZ rectangular coordinate system with the XYZ rectangular coordinate system set in the drawings, if necessary. The XYZ rectangular coordinate system is set in such a way that the X axis and the Z axis are parallel to the paper surface and that the Y axis is perpendicular to the paper surface. In the XYZ coordinate system in the drawings, an XY plane is set so as to be parallel to a horizontal surface and the Z axis is set in a vertical upward direction actually. Also, a direction (scanning direction) in which the wafer and the reticle R are moved synchronously during exposure is assumed to be set in the Y direction.

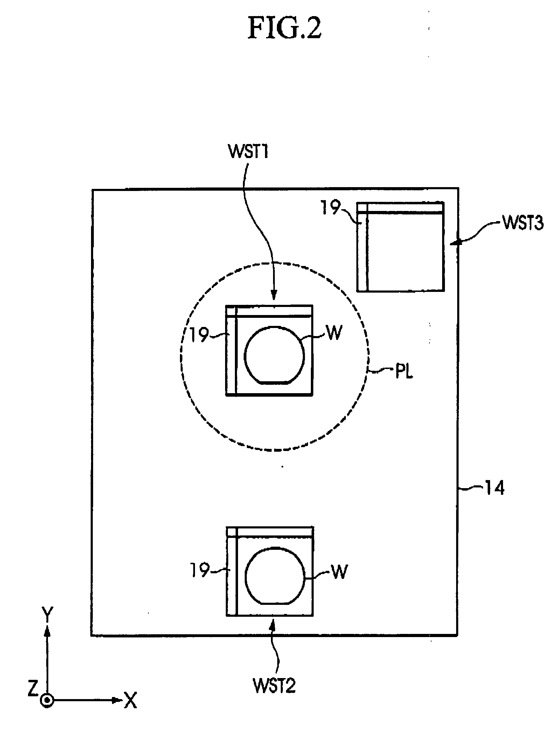

As shown in FIG. 1, the exposure device 10 includes an illumination optical system ILS, a reticle stage RST for holding the reticle R as a mask, a projection optical system PL, a wafer stage WST as stage device having stage units WST1 and WST2 for moving the water W as a substrate within the XY plane in a two-dimensional direction, namely the X direction or the Y direction, and a main control unit MCS for controlling these means. Although not shown in FIG. 1, the wafer stage WST also includes a stage unit WST3 (see FIG. 2) where various measuring apparatuses for measuring performance of the exposure device 10 in addition to the stage units WST1 and WST2. The stage unit WST3 will be described later.

The illumination optical system ILS illuminates a rectangular (or circular) illumination area LAR on the reticle R with uniform illuminance by shaping exposure light emitted from a light source unit (for example, an ultra high pressure halogen lamp or an excimer laser or other laser sources) which is not shown or by making its illumination distribution uniform. The reticle stage RST has a structure in which a stage movable part 11 is placed on a reticle base which is not shown. The stage movable part 11 moves along a predetermined scanning direction at a predetermined scanning speed on the reticle base during exposure.

Furthermore, the reticle R is held by, for example, vacuum suction on the top surface of the stage movable part 11. An exposure light through-hole (not shown) is formed in the lower part of the reticle R on the stage movable part 11. A reflecting mirror 12 is disposed at the end of the stage movable part 11. A laser interferometer 13 measures the position of the reflecting mirror 12 to thereby detect the position of the stage movable part 11. The detection result by the laser interferometer 13 is output to a stage control system SCS. The stage control system SCS drives the stage movable part 11 on the basis of the detection result by the laser interferometer 13 and a control signal from the main control unit MCS based on the moving position of the stage movable part 11. Although not shown in FIG. 1, a reticle alignment sensor is placed above the reticle stage RST so as to observe a mark (reticle mark) formed on the reticle R and a reference mark formed on a reference member which determines a reference position of the wafer stage WST simultaneously to measure a relative positional relation between them.

The projection optical system PL is a demagnification optical system, for example, having a demagnification of a (α is, for example, 4 or 5), which is placed below the reticle stage RST with its optical axis AX oriented in the Z axis direction. In this specification, there is employed a refracting optical system composed of a plurality of lens elements disposed at predetermined intervals along the optical axis AX so as to achieve a telecentric optical arrangement The lens elements are appropriately selected according to the wavelength of the light emitted from the light source unit. When the illumination optical system ILS illuminates the illumination area IAR of the reticle R, a reduced image (partial inverted image) of the pattern in the illumination area IAR of the reticle R is formed in an exposure area LA conjugate to the illumination area IAR on the wafer W.

FIG. 2 is a top view illustrating the configuration of the wafer stage WST. As shown in FIG. 1 and FIG. 2, the wafer stage WST includes a base member 14, stage units WST1 to WST3 supported in a floating manner by an air slider described later with a clearance of several microns (µm) above the top surface of the base member 14, and drive units 15 for driving the respective stage units WST1 to WST3 in the two-dimensional direction within the XY plane, The stage units WST1 and WST2 are provided to hold and carry the wafer W and the stage unit WST3 is provided to carry the various measuring apparatuses for measuring the performance of the exposure device 10. The various measuring apparatuses are attached to the stage unit WST3. The stage units WST1 to WST3 can be moved individually in an arbitrary direction within the XY plane by individually driving the drive units 15 provided in the stage units WST1 to WST3, respectively.

In the example shown in FIG. 2, the position where the stage unit WST2 is placed is the loading position of the wafer W. When unloading the wafer W after exposure or when loading the wafer W before exposure, one of the stage units WST1 and WST2 is placed in this position. Furthermore, in the example shown in FIG. 2, the position where the stage unit WST1 is placed is the exposure position. One of the stage units WST1 and WST2 holding the wafer W to be exposed is placed in this position during exposure. As described above, the stage units WST1 and WST2 can move in an arbitrary direction within the XY plane individually. Therefore, the loading position and the exposure position can be alternately replaced with each other. Moreover, the arrangement can be such that focusing information of the wafer is previously detected in the loading position.

The various measuring apparatuses provided in the stage unit WST3 are, for example, an illuminance sensor for measuring the illuminance of the exposure light emitted onto the wafer stage WST through the projection optical system PL, an uneven illuminance sensor for measuring uneven illuminance of the exposure light, an aerial image measurement system for measuring an aerial image of an optical image projected on the wafer stage WST through the projection optical system PL, an aberration measuring apparatus for measuring aberration of the projection optical system PL, and an apparatus for measuring the polarization of the exposure light emitted onto the wafer stage WST. In addition, the wafer stage WST3 is provided with the reference member having the reference mark which determines the reference position, the reference plane, or the like of the wafer stage WST. As described above; the stage unit WST3 can move in an arbitrary direction within the XY plane independently of the stage units WST1 and WST2. Therefore, it is possible to measure the illuminance or uneven illuminance of the exposure light emitted on the wafer stage WST, for example, by moving the stage unit WST3 below (in the -Z direction) the projection optical system PL before starting the exposure of the wafer W.

Note here that the drive unit 15 has a planar motor including a fixed part 16 provided (embedded) in the upper part of the base member 14 and a moving part 17 fixed to the bottom (on the side of the surface facing the base) of the stage units WST1 to WST3. The moving parts 17, the base member 14, and the drive units 15 constitute the planar motor device. The drive unit 15 is referred to as planar motor 15 for convenience in the following description.

The wafer W is fixed to each of the stage units WST1 and WST2, for example, by vacuum suction. A moving mirror 19 for reflecting a laser beam emitted from a laser interferometer 18 is fixed at one end of the stage units WST 1 to WST3, by which the external laser interferometer 18 always detects the position of the stage units WST1 to WST3 within the XY plane with a resolution of, for example, about 0.5 to 1 nm.

Although simply illustrated in FIG. 1, a moving mirror having a reflective surface perpendicular to the Y axis direction which is a scanning direction and a moving mirror having a reflective surface perpendicular to the X axis direction which is a non-scanning direction are provided on the stage units WST1 to WST3 and the laser interferometers 18 are provided for one axis in the scanning direction and for two axes in the non-scanning directions. In FIG. 1, however, they are typically shown as the moving mirror 19 and the laser interferometer 18. FIG. 1 shows a state in which a laser beam from the laser interferometer 18 is emitted to the moving mirror 19 provided on the stage unit WST1 and the same laser interferometer is provided for the stages WST2 and WST3. The position information (or velocity information) of the stage units WST1 to WST3 is transmitted to the stage control system SCS and therethrough to the main control unit MCS. The stage control system SCS controls movements within the XY plane of the stage units WST1 to WST3 through the planar motors 15 based on each position information (or velocity information) of the stage units WST1 to WST3 according to an instruction of the main control unit MSC.

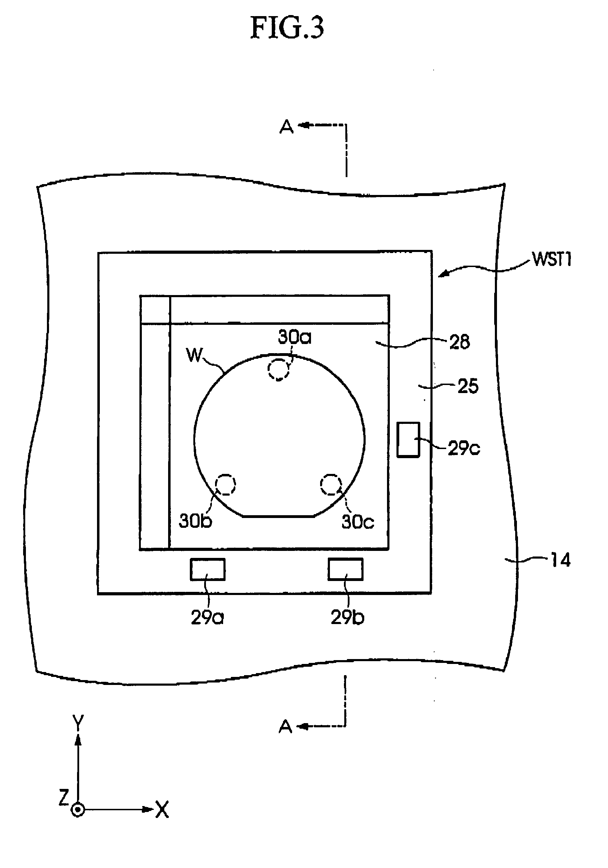

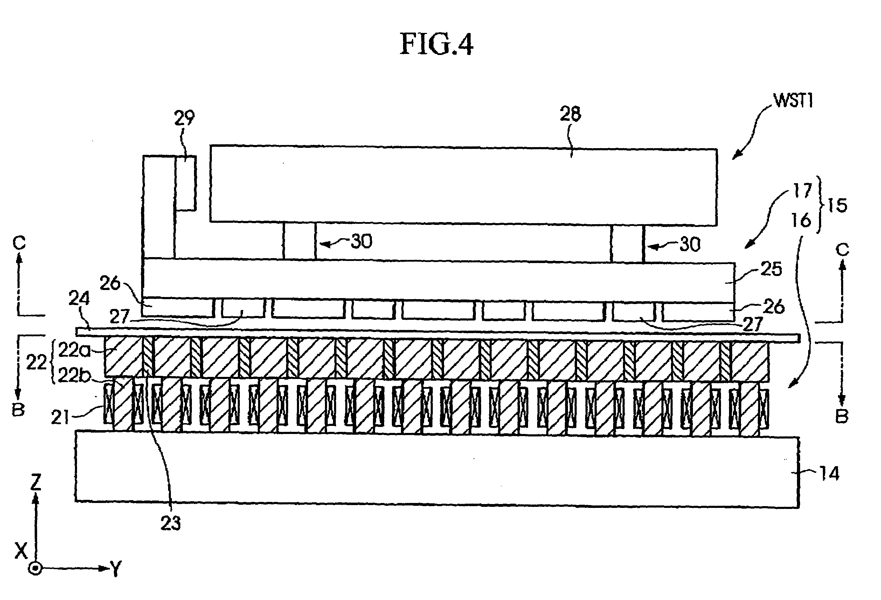

The configuration of the wafer stage WST will be described in detail below. FIG. 3 shows a top view of the stage unit WST1 provided on the stage WST and FIG. 4 shows a cross-sectional view on arrow A-A of FIG. 3, In FIG. 3 and FIG. 4, the same members as in FIG. 1 and FIG. 2 are designated by the identical reference numerals. Furthermore, the stage unit WST1 has the same configuration as the stage unit WST2, and therefore the stage unit WST1 is described here as typical.

As shown in FIG. 3 and FIG. 4, a first stage 25 which forms a part of the stage unit WST1 is supported in a floating manner with a predetermined clearance (in the order of several microns) above the fixed part 16 provided on the top of the base member 14. Coils 21 are wound around the fixed part 16 which forms a part of the wafer stage WST, and the fixed part 16 is provided with core members 22 arranged at predetermined pitches within the XY plane. The core member 22 is made of, for example, low carbon steel equivalent to SS400 or a magnetic material such as stainless steel, and consists of a head 22a and a support 22b. The head 22a has a rectangular cross section within the XY plane and the support 22b has a circular cross section within the XY plane. The head 22a and the support 22b are integrated with each other and the coil 21 is wound around the support 22b. Note here that, however, the shape (the XY cross section or the like) of the core member 22 is not particularly limited. The head 22a and the support 22b can be a single piece or can be individually manufactured and then bonded together.

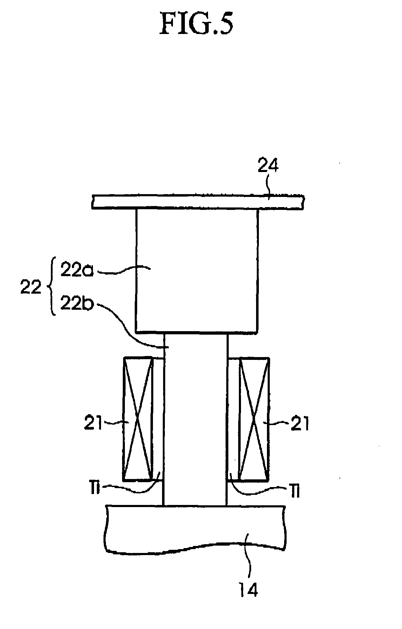

FIG. 5 shows an enlarged view of the core member 22. As shown in FIG. 5, the coil 21 is wound around the support 22b of the core member 22 through thermal insulation Ti. This arrangement is intended to prevent an alignment error on the stage units WST1 to WST3 caused by transmission to the core member 22 of heat generated when the current is applied to the coil 21. More specifically, if the heat from the coil 21 is transmitted to the core member 22, the core member 22 expands and thereby causes a displacement of the core member 22 in the XY plane or the core member 22 expands in the Z direction and thereby causes unevenness of a guide surface 24 described later, which leads to an alignment error on the stage units WST1 to WST3. The thermal insulation Ti can be a resin which is excellent in thermal insulation and heat resistance. While the thermal insulation Ti is provided between the core member 22 and the coil 21 for insulation between them in this embodiment, the present invention is not limited thereto. For example, the core member 22 and the coil 21 can be supported in a manner that prevents contact between them while maintaining the magnetic connection between the core member 22 and the coil 21. In that case, it is possible to reduce the tendency of the heat conduction of the coil 21 to the core member 22 by the passage of temperature-controlled air or a refrigerant described later between the core member 22 and the coil 21. Alternatively, the heat can be discharged by using a heat sink or the like.

The core members 22 are arranged on the base member 14 in such a way that the leading edges of the heads 22a are set to be within a substantially one plane. In this condition, the supports 22b of the core members 22 are magnetically connected to the base member 14. A separator 23 made of a nonmagnetic material is provided between the heads 22a of the core members 22. The separator 23 is formed of, for example, SUS or ceramic and is intended to prevent the formation of a magnetic circuit between adjacent core members 22. It is also provided to prevent displacement of the heads 22a of the core members 22. The separator 23 can be one plate member having a plurality of openings formed therein to receive the heads 22a of the plurality of core members 22. It, however, is not limited thereto, but can be separated into a plurality of members.

The height position of the top of the separator 23 is adapted to be the same as the height position of the leading edge of the head 22a of the core member 22. Therefore, the top (moving surface) of the fixed part 16 is substantially flat. In addition, the separator 23 is provided between the heads 22a of the core members 22 and a space is formed with being vertically sandwiched between the base member 14 and the heads 22a of the core members 22 with the separator 23. The coil 21 can be cooled down by introducing a refrigerant into this space. The refrigerant is a liquid having good electrical insulation properties. For example, the refrigerant can be water (pure water) or alcohol, ether, or an organic solvent such as hydro fluoro ethers (HFE) or Fluorinert^{™}. The refrigerant is temperature controlled at a predetermined temperature by a circulation system, which is not shown, so as to be supplied to the space described above. In this embodiment, the heads 22a of the core members 22 and the separator 23 constitute a wall surface which forms a part of the flow path of the refrigerant. It should be noted that appropriate waterproofing is carried out for the heads 22a of the core members 22 and the separator 23 before the passage of the refrigerant.

A guide member 24 is provided on the top surface of the fixed part 16. The guide member 24 acts as a guide plate which moves the stage units WST1 to WST3 within the XY plane and is formed of a nonmagnetic material. The guide member 24 is as thin as several hundred microns or so in thickness, and therefore a magnetic material can be used for the guide member 24 if the nonmagnetic material cannot be used. The guide member 24 is formed by thermal spraying, for example, alumina (Al₂O₃) to the top surface of the flat fixed part 16 and blowing high-pressure gas toward the metal surface. The guide member 24 can be formed of any other ceramic, SUS, or the like.

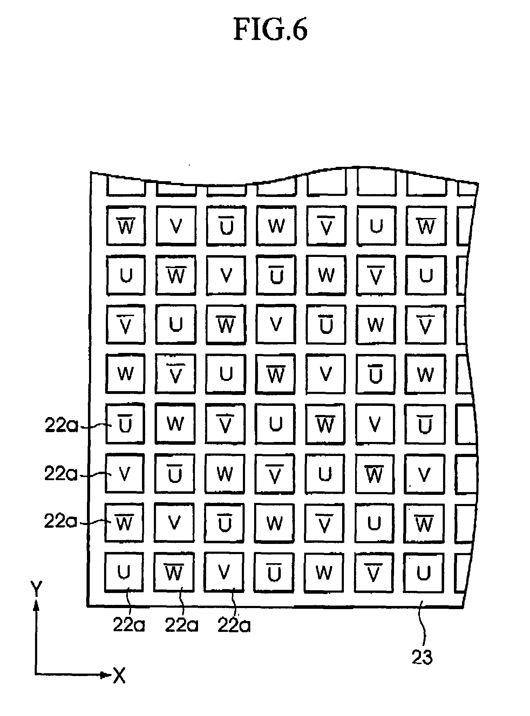

Three-phase AC power consisting ofU, V, and W phases is supplied to the coils 21 provided on the fixed part 16. The respective phases of the current are applied to the coils 21 arranged within the XY plane respectively at predetermined timings in a predetermined order, by which the stage units WST1 to WST3 can be moved in a desired direction at a desired speed. FIG. 6 shows a cross-sectional view on arrow B-B of FIG. 4. As shown in FIG. 6, the heads 22a of the core members 22 each having a rectangular cross section are arranged in a matrix within the XY plane with the separator 23 placed between the heads 22a.

Focusing on one of the core members 22 here, the separator 23 is provided between the head 22a of the core member 22 focused on and the head of the core member 22 adjacent thereto in the X direction (first direction), and the separator 23 is provided between the head 22a of the core member 22 focused on and the head of the core member 22 adjacent thereto in the Y direction (second direction). In FIG. 6, the phases of the three-phase AC power applied to the coils 21 each wound around the corresponding core member 22 are shown with being associated with the heads 22a of the core members 22. As apparent from FIG. 6, the U, V, and W phases (including U̅, V̅, and W̅ phases) are arranged regularly within the XY plane.

Subsequently, the moving part 17 forming a part of the wafer stage WST includes the first stage 25, permanent magnets 26, air pads 27, a second stage 28, a horizontal drive mechanism 29, and a vertical drive mechanism 30. The permanent magnets 26 and the air pads 27 are arranged regularly on the bottom surface of the first stage 25. For the permanent magnets 27, it is possible to use a neodymium-iron-cobalt magnet, an aluminum-nickel-cobalt (alnico) magnet, a ferrite magnet, a samarium-cobalt magnet, a neodymiuttl-iran-boron magnet or other rare earth magnets.

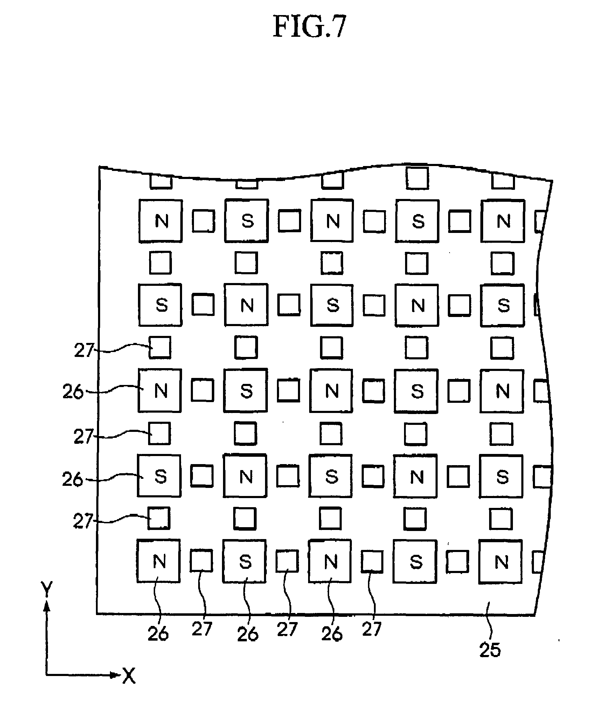

FIG. 7 shows a cross-sectional view on arrow C-C of FIG. 4. As shown in FIG. 7, the permanent magnets 26 are arranged at predetermined intervals within the XY plane in such a manner that adjacent permanent magnets 26 have different poles from each other. With this arrangement, alternating magnetic fields are formed both in the X and Y directions. In addition, the air pads 27 are each provided between the permanent magnets 26. The air pads 27 support the moving part 17 in a floating manner with a clearance of, for example, several microns or so above the fixed part 16 by blowing air against the guide member 24 and function as a part of air bearing. In addition, it is possible to use a preloaded type bearing which is preloaded by vacuum or the like.

The second stage 28 is supported by the vertical drive mechanism on the first stage 25. The vertical drive mechanism 30 has, for example, support mechanisms 30a, 30b, and 30c (see PIG. 3) including, for example, a voice coil motor (VCM) and supports the second stage 28 at different three points by means of the support mechanisms 30a, 30b, and 30c. The support mechanisms 30a, 30b, and 30c are extendable and retractable in the Z direction. The second stage 28 can be moved in the Z direction by driving the support mechanisms 30a, 30b, and 30c with the same amount of extension or retraction, and a rotation around the X axis and a rotation around the Y axis of the second stage 28 can be controlled by driving the support mechanisms 30a, 30b, and 30c independently of each other or driving them with amounts of extension or retraction different from each other.

The horizontal drive mechanism 29 has drive mechanisms 29a, 29b, and 29c (see FIG. 3) including, for example, a voice coil motor (VCM) and controls the position of the second stage 28 within the XY plane and the rotation thereof around the Z axis by means of the drive mechanisms 29a, 29b, and 29c, More specifically, the position of the second stage 28 in the Y direction can be varied by driving the drive mechanisms 29a and 29b with the same amount of extension or retraction, the position of the second stage 28 in the X direction can be varied by driving the drive mechanism 29c, and the rotation of the second stage 28 around the Z axis can be varied by driving the drive mechanisms 29a and 29b with amounts of extension or retraction different from each other. In short, it can be said that the first stage 25 driven by the above planar motor 17 is a coarse adjustment stage and the second stage 28 driven by the horizontal drive mechanism 29 is a fine adjustment stage. The horizontal drive mechanism 29 and the vertical drive mechanism 30 adjust the position of the second stage 28 within the XY plane and the position thereof in the Z direction under the control of the stage control system SCS.

When moving the stage unit WST1 having the above configuration, it is possible to use the same driving method as for a well-known linear motor driven by three-phase AC power. More specifically, the stage unit WST1 is considered to include a linear motor movable in the X direction and a linear motor movable in the Y direction. When moving the stage unit WST1 in the X direction, the three-phase AC power is applied to the coils 21 arranged in the X direction in the same manner as the linear motor movable in the X direction. When moving the stage unit WST1 in the Y direction, the three-phase AC power is applied to the coils 21 arranged in the Y direction in the same manner as the linear motor movable in the Y direction. For example, upon application of the alternating current of each phase is applied to the corresponding coils 21, the core members 22 around which the coils 21 are wound function as electromagnets. Attraction and repulsion act between a magnetic force (magnetic flux) generated by the electromagnets and the permanent magnets 26 arranged in the stage unit WST (moving part 17), This action occurs between each core member 22 and each permanent magnet 26, and therefore the stage unit WST can be moved toward a desired position by controlling the three-phase AC power.

In the wafer stage WST having the above configuration, the core members 22 are arranged within the XY plane in such a manner that the leading edges of the heads 22a are set to be within a substantially one plane in the fixed part 16, with the coil 21 wound around each of the core members 22. Therefore, the magnetic flux generated by applying the current to the coil 21 can be guided to the bottom surface of the stage unit WST1 effectively with low loss. For this reason, it is possible to reduce the thickness of the permanent magnets 26 on the bottom surface of the first stage 25 of the stage unit WST1 and to thereby reduce the weight of the stage unit WST1 . Note here that, even if the magnetic flux generated by the permanent magnets 26 weakens due to the reduction in thickness of the permanent magnets 26, the magnetic flux generated from the coils 21 by the core members 22 can be guided to the bottom surface of the stage unit WST1 with low loss and therefore it does not decrease the thrust force.

In this embodiment, the stage unit WST1 is reduced in weight without decreasing the thrust force and therefore the stage unit WST1 can be accelerated at high acceleration as well as providing a higher aligning accuracy. Note here that the heat generated by applying the current to the coils 21 can be removed by the refrigerant introduced into the space vertically sandwitched between the base member 14 and the heads 22a of the core members 22 with the separator 23. Moreover, the coil 21 is wound around the support 22b of the core member 22 through the thermal insulation Ti, which prevents deterioration of the aligning accuracy caused by expansion or deformation of the core member 22 due to heat transmitted from the coil 21 to the core member 22. According to the above, the stage unit WST1 can be driven efficiently in this embodiment. The stage units WST2 and WST3 present the same operation/working-effect as that in the above description.

Returning to FIG. 1, the exposure device 10 of this embodiment includes an air pump 40 for supplying a pressurized air to the air pads 27 shown in FIG. 4. The air pump 40 and the stage units WST1 and WST2 are connected via tubes 41 and 42, respectively. Air from the air pump 40 is supplied to the stage unit WST1 via the tube 41 and to the stage unit WST2 via the tube 42. Furthermore, the exposure device 10 is provided with a cooling system 43 for cooling down the coils 21 shown in FIG. 4. The cooling system 43 is connected to the base member 14 via a refrigerant supply line 44 and a refrigerant discharge line 45, The refrigerant from the cooling system 43 is supplied to the base member 14 (the portion where the coils 21 in the fixed part 16 are provided) via the refrigerant supply line 44, and the refrigerant passing through the base member 14 is collected in the cooling system 43 via the refrigerant discharge line 45. For example, in FIG. 4, the device can be adapted to supply water or other refrigerant to the space vertically sandwitched between the guide member 24 and the base member 14 and having the coils 21, the core members 22, and the separator 23 arranged therein.

Although not shown in FIG. 1, the exposure device 10 is provided with an off-axis wafer alignment sensor for measuring the position information of an alignment mark formed on the wafer W adjacent to one side of the projection optical system PL or provided with a through-the-lens (TTL) type alignment sensor for measuring the position information of an alignment mark formed on the wafer W through the projection optical system PL. Furthermore, the exposure device 10 is provided with an auto-focus mechanism and an auto-leveling mechanism for detecting the position and posture of the wafer W in the Z direction (the rotation around the X axis and the rotation around the Y axis) by irradiating the wafer W with a slit of detection light in an oblique direction to measure its reflected light and for correcting the position and posture of the wafer W in the Z direction based on the detection result so that the surface of the wafer W matches the image surface of the projection optical system PL.

The above has described the structures of the planar motor device, the stage device, and the exposure device according to the embodiment of the present invention. Subsequently, the operations thereof during exposure will be described briefly. When exposure processing is performed for one lot of wafer W, the exposure processing is started after measuring the performance of the exposure device by using, for example, various measuring apparatuses provided in the stage unit WST3. Upon the start of the performance measurement of the exposure device, the main control unit MCS retracts, for example, both of the stage units WST1 and WST2 from the exposure positions and places the stage unit WST3 in its exposure position instead. In addition, the main control unit MCS controls a reticle loader, which is not shown, to load a reticle having no pattern (test reticle) on the reticle stage RST.

In this state, the main control unit MCS sets optical properties of the illumination optical system ILS (the numerical aperture of the aperture stop, illumination condition, and the like), emits exposure light from the light source unit which is not shown, and measures the illuminance and uneven illuminance of the exposure light, which sequentially passes through the reticle R and the projection optical system PL and are applied to the stage unit WST3, by using the illuminance sensor and the uneven illuminance sensor, respectively. Moreover, it measures a residual aberration of the projection optical system PL by using an aberration measuring apparatus. After the completion of the measurements, the main control unit MCS controls the optical properties of the illumination optical system ILS based on the obtained measurement results and controls the imaging performance of the projection optical system PL by moving one or more lens elements provided in the projection optical system PL in the optical axis AX direction or by decentering them relative to the optical axis AX.

After the completion of the above processing, for example, a baseline measurement is performed. The term "baseline" means a distance between the center position of a projection image, for example, of the pattern on the reticle R projected by the projection optical system PL and the center of the measurement field-of-vision of the wafer alignment sensor provided adjacent to one side of the projection optical system PL. To perform the baseline measurement, first the main control unit MCS controls the reticle loader, which is not shown, to unload the reticle held on the reticle stage RST and to load a reticle R to be used first in the exposure processing onto the reticle stage RST.

Subsequently, the reticle alignment sensor, which is not shown, is used to simultaneously observe the reticle mark formed on the reticle R and the reference mark on the reference member provided in the stage unit WST disposed in the exposure position so as to measure the positional displacement amount of the reticle mark relative to the reference mark. Thereafter, the main control unit MCS places the stage unit WST3 under the wafer alignment sensor by moving it by a predetermined amount, places the reference mark formed on the reference member within the measurement field-of-view of the wafer alignment sensor, and then measures the position information of the reference mark by using the wafer alignment sensor. The baseline is obtained from the measurement result of the reticle alignment sensor and the measurement result of the wafer alignment sensor described above.

After the completion of the various measurements, the main control unit MCS retracts the stage unit WST3 from the exposure position and places, for example, the stage unit WST1 in the loading position. It then places the stage unit WST1 with the wafer W held at the top of the lot under the wafer alignment sensor and measures the positions of several (three to nine) alignment marks on the wafer W. Thereafter, the main control unit MCS performs the enhanced global alignment (EGA) operation based on the measurement result to determine the regularity of the arrangement of all shot areas set on the wafer W. The term "EGA operation" means an operation method of determining the regularity of the arrangement of all shot areas set on the wafer W in a statistical technique on the basis of the position information of the marks (alignment marks) respectively appended to several (three to nine) typical shot areas preset on the wafer W and design information of the marks.

After determining the arrangement of the shot areas on the wafer W by the above EGA operation, the main control unit MCS corrects the coordinate value of the obtained shot area by the baseline described above. Each shot area on the wafer W can be aligned with the exposure area IA of the projection optical system PL by driving the stage unit WST1 using the corrected coordinate value. The exposure device 10 in this embodiment is a step-and-scan type exposure device. Therefore, to expose the shot area, the reticle stage RST and the stage unit WST1 are accelerated to a predetermined speed so as to be synchronized with each other, and thereafter the main control unit MCS controls the illumination optical system ILS to emit the exposure light to illuminate the reticle R to thereby project the image of the pattern on the reticle R onto the wafer W through the projection optical system PL.

During scanning, a part of the pattern image on the reticle R is projected onto the exposure area IA, while the wafer W moves at velocity β•V (β is a projection magnification) in the +X direction (or -X direction) in synchronization with the movement of the reticle R at velocity V in the -X direction (or +X direction) with respect to the projection optical system PL. After the completion of the exposure processing for one shot area, the main control unit MCS moves the stage unit WST1 step by step to move the next shot area to the scanning start position. Hereinafter, the exposure processing is sequentially performed for other shot areas similarly in the step-and-scan method.

While the embodiment of the present invention has been described hereinabove, it is to be understood that the present invention is not limited to the above-described embodiment and allows various alterations or modifications within the scope of the present invention. For example, although the foregoing embodiment has been described with respect to the case where the present invention is applied to the step-and-scan type exposure device, the present invention is also applicable to a step-and-repeat type exposure device (so-called stepper).

Moreover, the foregoing embodiment has been described with respect to the case of a so-called moving magnet type wafer stage WST in which the permanent magnets 26 are provided in the moving part 17 of the stage unit WST1 and the coils 21 are provided in the fixed part 16. The present invention, however, is also applicable to a so-called moving coil type wafer stage in which coils are provided in a moving part of a stage unit and permanent magnets are provided in a fixed part. Furthermore, although the foregoing embodiment has been described with respect to the case where the present invention is applied to the wafer stage WST, the present invention is also applicable to the reticle stage RST and further applicable to both of the reticle stage RST and the wafer stage WST.

Moreover, the light source unit provided in the exposure device is not limited to an excimer laser such as a KrF excimer laser (248 nm) or an ArF excimer laser (193 nm), but it is possible to use a g-line (436 nm) or i-line (365 nm) emitted from an extra-high pressure mercury lamp, a laser beam emitted from a F₂ laser (157 nm), a laser beam emitted from a Kr₂ laser (146 nm), a laser beam emitted from an Ar₂ laser (126 nm), and a charged particle beam such as an X-ray or electron beam.

Furthermore, the exposure device according to the present invention is also applicable to exposure device for use in manufacturing a semiconductor device to transfer a device pattern onto a semiconductor substrate, exposure device for use in manufacturing a liquid crystal display device to transfer a circuit pattern onto a glass plate, exposure device for use in manufacturing a thin-film magnetic head to transfer a device pattern onto a ceramic wafer, and exposure device for use in manufacturing an image pickup device such as a CCD.

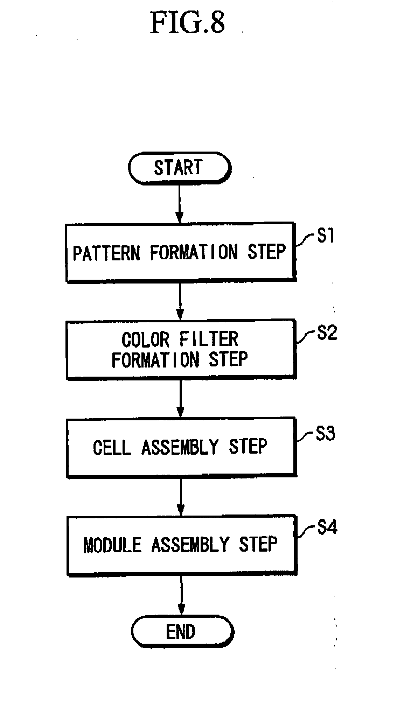

The following describes a method of manufacturing a liquid crystal display device using the exposure device according to one embodiment of the present invention. FIG. 8 shows a flowchart of a part of a manufacturing process for manufacturing a liquid crystal display device as a microdevice. In a pattern formation step S1 in FIG. 8, a so-called photolithography process is performed to transfer the mask pattern onto the wafer W and expose the wafer W by using the exposure device of this embodiment. As a result of the photolithography process, a predetermined pattern including a number of electrodes and the like are formed on the wafer W. Thereafter, the exposed wafer W is subjected to individual steps such as a development step, an etching step, and a stripping step, whereby a predetermined pattern is formed on the wafer W. Thereafter, the control proceeds to the next color filter formation step S2.

In a color filter formation step S2, there is formed a color filter in which a number of groups of three dots corresponding to R (Red), G (Green), and B (Blue) are arranged in a matrix or a color filter in which a plurality of groups of filters of three stripes of R, G, and B are arranged in a horizontal scanning line direction.

Subsequently, a cell assembly step (S3) is performed after the color filter formation step S2. In the cell assembly step S3, the wafer W having a predetermined pattern obtained in the pattern formation step S1, the color filter obtained in the color filter formation step S2, and the like are used to assemble a liquid crystal panel (liquid crystal cell).

In the cell assembly step S3, a liquid crystal is injected between the wafer W having the predetermined pattern obtained in the pattern formation step S1 and the color filter obtained in the color filter formation step S2, for example, so as to manufacture the liquid crystal panel (liquid crystal cell). Thereafter, in a module assembly step S4, parts such as an electric circuit for causing the assembled liquid crystal panel (liquid crystal cell) to carry out display operations, a backlight, and the like are attached to the liquid crystal panel, so as to accomplish a liquid crystal display device. According to the liquid crystal display device manufacturing method mentioned above, a liquid crystal display device having quite minute circuit patterns can be obtained with a favorable throughput.

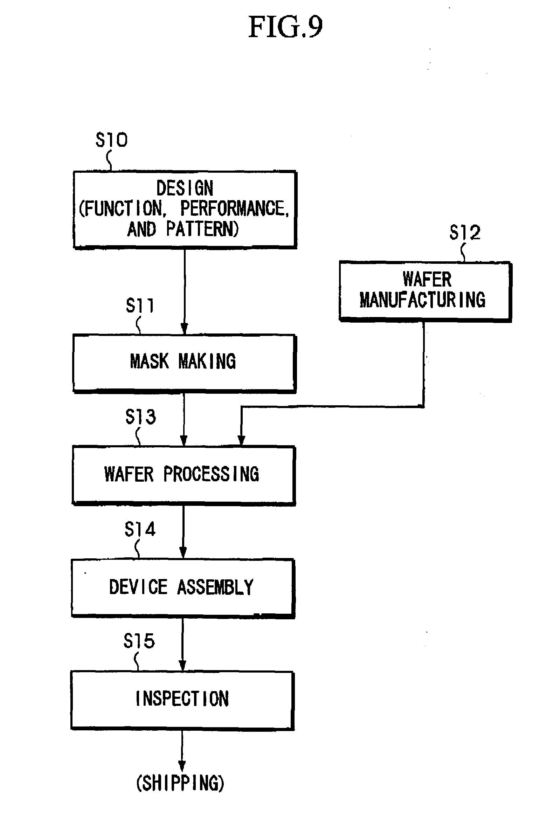

The following describes a method of applying the exposure device according to the embodiment of the present invention to exposure device for manufacturing a semiconductor device so as to manufacture the semiconductor device using this exposure device. FIG. 9 shows a flowchart of a part of a manufacturing process for manufacturing a semiconductor device as a microdevice. As shown in FIG. 9, first in step S10 (design step), the function and performance of the semiconductor device are designed and then a pattern to implement the function is designed Subsequently, in step S11 (mask making step), a mask (reticle) on which the designed pattern is formed is made. On the other hand, in step S 12 (wafer manufacturing step), a wafer is manufactured using a material such as silicon.

Next, in step S13 (wafer processing step), an actual circuit or the like is formed on the wafer by lithography using the mask and the wafer prepared in steps S10 to S12 as described later. Subsequently, in step S 14 (device assembly step), a device is assembled using the wafer processed in step S 13. This step S 14 includes steps such as dicing, bonding, and packaging (chip encapsulation), as required. Finally, in step S15 (inspection step), tests on operation, durability, and so forth are performed on the microdevice made in step S 14. After these steps, the microdevice is completed and shipped.

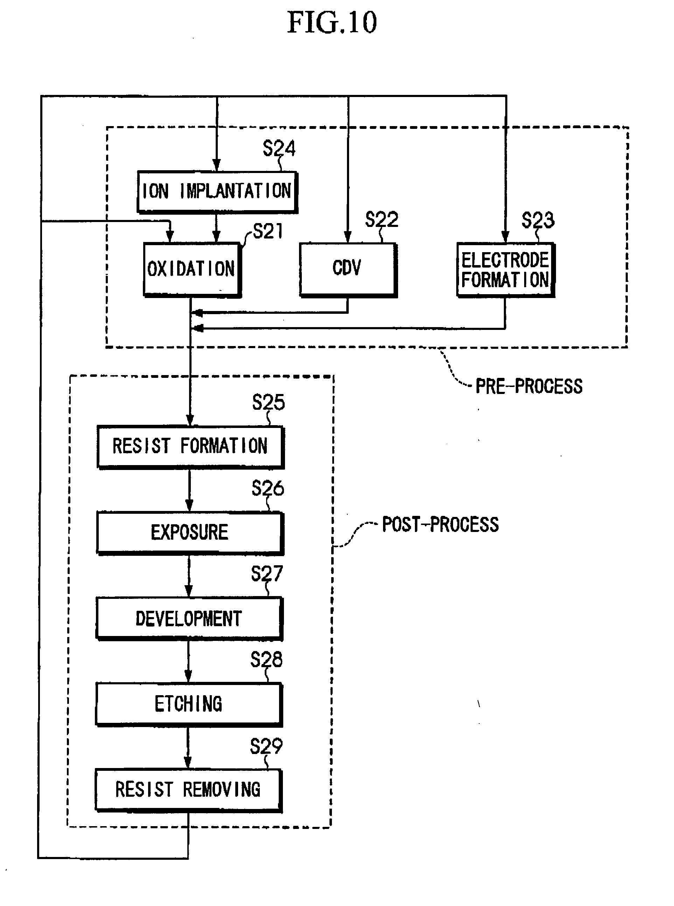

FIG. 10 shows an example of a detailed flow of step S13 shown in FIG. 9. In FIG. 10, the surface of the wafer is oxidized in step S21 (oxidation step). In step S22 (CVD step), an isolating film is formed on the wafer surface. In step S23 (electrode formation step), an electrode is formed on the wafer by vapor deposition. In step S24 (ion implantation step), ions are implanted into the wafer. Steps S21 to S24 described above constitute a pre-proeess for the respective steps in the wafer process, and are selectively performed in accordance with processing required in each step.

After the completion of the above pre-process in the respective steps in the wafer process, a post-process is performed as described below. In this post-process, first in step S25 (resist formation step), a photosensitive agent is applied onto the wafer. Subsequently, in step S26 (exposure step), the mask pattern is transferred onto the wafer using the above-mentioned lithography system (exposure device) and the exposure method. Next, in step S27 (development step), the exposed wafer is developed, and in step S28 (etching step), exposed portions other than those on which the resist remains are removed by etching. Then, in step S29 (resist removing step), the resist unnecessary after the etching is removed. By repeating these pre-process and post-process steps, patterns are formed in multiple layers on the wafer.

Using the microdevice manufacturing method according to this embodiment described hereinabove, the stage holding the reticle (mask) and the stage holding the plate (wafer) are scanned with the above exposure device in the pattern formation step (step S1) or the exposure step (step S26). Therefore, it is possible to reduce the time for movement between the reticle (mask) and the plate (wafer) and to increase the superposition accuracy, whereby a fine device can be efficiently produced with high yield.

In addition to the microdevice such as the liquid crystal display device or the semiconductor device, the present invention is applicable to exposure device for transferring a pattern from a mother reticle to a glass substrate, a silicon wafer, or the like in order to manufacture a reticle or mask for use in an optical aligner, an EUV exposure apparatus, an X-ray exposure apparatus, an electron-beam exposure apparatus, and so forth, In the case of an exposure apparatus using deep ultraviolet (DUV) or vacuum ultraviolet (VUV) light, a transmissive reticle is typically used, and quartz glass, quartz glass doped with fluorine, fluorite, magnesium fluoride, quartz crystal, or the like is used as the reticle substrate. Moreover, in the case of an X-ray exposure apparatus or an electron-beam exposure apparatus based on a proximity system, a transmission mask (stencil mask or membrane mask) is used, and a silicon wafer or the like is used as the mask substrate. Such exposure device is disclosed in International Publication Nos. WO 99/34255, 99/50712, and 99/66370, and Japanese Patent Laid-Open Nos. Hei 11(1999)-194479,2000-12453, and 2000-29202. The disclosure of the above pamphlets and publications is incorporated herein as part of this specification within a range of permission of the domestic laws and ordinances of the countries designated (or selected) in this international application.

Although the embodiment has been described with respect to the case where the exposure device has a plurality of stages, the present invention is also applicable to exposure device having only one stage.

Exposure device having a plurality of stages as in this embodiment is disclosed, for example, in Japanese Patent Laid-Open Nos. Hei 10(1998)-163099, Hei 10(1998)-214783 and US Patent No. 6,400,441 corresponding thereto, Published Japanese translation of PCT International Publication for Patent Application No. 2000-505958 and US Patent No. 5,969,441 corresponding thereto, and US Patent No. 6,262,796. The disclosure of the above publications and US Patents are incorporated herein as part of this specification within a range of permission of the domestic laws and ordinances of the countries designated (or selected) in this international application,

While the embodiment has been described with respect to the case of the exposure device, which includes an exposure stage movable while holding a substrate to be processed such as a wafer and a measurement stage equipped with various measuring members and sensors, this type of exposure device is disclosed, for example, in Japanese Patent Laid-Open No. Hei 11(1999)-135400. The disclosure of the above publication is incorporated herein as part of this specification within a range of permission of the domestic laws and ordinances of the countries designated (or selected) in this international application.

In the foregoing embodiment, a light-transmitting mask with a predetermined light-shielding pattern (or phase pattern or light-reducing pattern) formed on a light-transmitting substrate, or a light-reflecting mask with a predetermined reflection pattern formed on a light-reflecting substrate is used, but the present invention is not limited thereto. For example, instead of such a mask, an electronic mask (as part of an optical system) may be used, which forms a transmission pattern, a reflection pattern, or a luminous pattern based on electronic data of the pattern to be exposed. Such an electronic mask is disclosed, for example, in US Patent No. 6,778,257. The disclosure of the above US Patent is incorporated herein as part of this specification within a range of permission of the domestic laws and ordinances of the countries designated (or selected) in this international application. Note that the electronic mask is a concept including both a non-luminous type image display element and a self-luminous type image display element.

Furthermore, the present invention is applicable to exposure device for exposing a substrate to interference fringes caused by a plurality of light beams interfering with one another such as, for example, exposure device for performing so-called two-beam interference exposure. Such an exposure method and exposure device are disclosed, for example, in International Publication No. WO 01/35168. The disclosure of the above pamphlet is incorporated herein as part of this specification within a range of permission of the domestic laws and ordinances of the countries designated (or selected) in this international application.

Furthermore, the present invention is also applicable to immersion exposure device in which exposure is performed through a liquid with a space between a projection optical system PL and a substrate (wafer) W filled with the liquid. Such immersion exposure device is disclosed, for example, in International Publication No. WO 2004/053958, in which the space between the projection optical system 30 and the substrate W is locally filled with liquid. The disclosure of the above pamphlet is incorporated herein as part of this specification within a range of permission of the domestic laws and ordinances of the countries designated (or selected) in this international application.

Furthermore, the present invention is applicable to immersion exposure device in which a stage holding a substrate (wafer) W to be exposed is moved in a liquid bath, or immersion exposure device in which a liquid bath is formed to a predetermined depth on a stage so that a substrate will be held in the liquid bath. The structure of the immersion exposure device in which the stage holding the substrate to be exposed is moved in the liquid bath and its exposure operation are disclosed, for example, in Japanese Patent Laid-Open No. Hei 6(1994)-124873, and the immersion exposure device in which the liquid bath is formed to a predetermined depth on the stage so that the substrate will be held in the liquid bath is disclosed, for example, in Japanese Patent Laid-Open No. Hei 10(1998)-303114 and US Patent No. 5,825,043. The disclosure of the above publications and US Patent is incorporate herein as part of this specification within a range of permission of the domestic laws and ordinances of the countries designated (or selected) in this international application.

Further, the present invention is not limited to the structure of filling an optical path space on the irradiation side of an end optical member of the projection optical system 30 with a liquid (pure water) to expose a substrate W (wafer). As disclosed in International Publication No. WO 2004/019128, an optical path space on the incidence side of the end optical member of the projection optical system may also be filled with the liquid (pure water). The disclosure of the above pamphlet is incorporated herein as part of this specification within a range of permission of the domestic laws and ordinances of the countries designated (or selected) in this international application.

Furthermore, the reaction force generated by the movement of the wafer stage WST may be dissipated mechanically to the floor (ground) using a frame member so as not to transmit to the projection optical system PL, as disclosed in Japanese Patent Laid-Open No. Hei 8(1996)-166475 (US Patent No. 5,528,118). In addition, the reaction force generated by the movement of the reticle stage RST may be dissipated mechanically to the floor (ground) using a frame member so as not to transmit to the projection optical system PL, as disclosed in Japanese Patent Laid-Open No. Hei 8(1996)-330224 (US S/N 08/416,558),

## Claims

1. Planar motor device comprising a fixed part which forms a predetermined moving surface and a moving part which is movable along the moving surface,
wherein the fixed part includes a plurality of core members arranged along the moving surface and each including a magnetic material and coils magnetically connected to the core members, respectively, and
wherein the moving part includes magnetic members arranged along the moving surface on the side opposite to the fixed part.

2. Planar motor device according to claim 1, wherein the fixed part supports the respective core members and is provided with a base member for magnetically connecting the core members.

3. Planar motor device according to claim 1 or 2, wherein the fixed part includes a separator made of a nonmagnetic material provided between the core members.

4. Planar motor device according to claim 3,
wherein the plurality of core members are arranged in a matrix within a plane substantially parallel to the moving surface, and
wherein the separator made of the nonmagnetic material is placed between at least one of the core members and a core member adjacent thereto in a first direction and between at least one of the core members and a core member adjacent thereto in a second direction substantially perpendicular to the first direction

5. Planar motor device according to one of claims 1 to 4, wherein the fixed part has a plane substantially parallel to the moving surface and includes a guide member placed between the core members and the moving part.

6. Planar motor device according to claim 5, wherein the guide member includes ceramic.

7. Planar motor device according to claim 5 or 6, wherein the ceramic is formed by thermal spraying.

8. Planar motor device according to one of claims 1 to 7, wherein the core members and the separator constitute a wall surface which forms a part of a flow path of refrigerant for cooling down the coils,

9. Planar motor device according to one of claims 1 to 8, wherein the moving part includes a stage on which an object is mounted and an adjustment mechanism that adjusts at least one of the position and the posture of the stage.

10. Planar motor device according to claim 9, wherein the adjustment mechanism adjusts the position of the table in two intersecting directions within the plane parallel to the moving surface and in at least one direction intersecting the moving surface.

11. Planar motor device according to claim 9, wherein the adjustment mechanism adjusts the posture of the stage by adjusting the amount of rotation of the table around the two intersecting directions within the plane parallel to the moving surface and around at least one direction intersecting the moving surface,

12. Planar motor device according to one of claims 1 to 11, wherein the moving part has a plurality of air outlets on the side opposite to the fixed part.

13. Planar motor device according to one of claims 1 to 12, wherein thermal insulation is provided between the core members and the coils.

14. Planar motor device according to one of claims 1 to 13, wherein a plurality of moving parts movable along the moving surface are provided.

15. Stage device comprising a stage on which an object is mounted, wherein the planar motor device according to one of claims 1 to 14 is provided therein as driver of the stage.

16. Exposure device, provided with a mask stage that holds a mask and a substrate stage that holds a substrate, and transfers a pattern formed on the mask onto the substrate, wherein the exposure device is provided with the stage device according to claim 15 as at least one of the mask stage and the substrate stage.

17. A device manufacturing method including a lithography process, wherein the exposure device according to claim 16 is used in the lithography process.
